(19) Europäisches Patentamt / European Patent Office / Office européen des brevets

(11) **EP 3 872 989 A1**

(12) **EUROPEAN PATENT APPLICATION**

(43) Date of publication:
**01.09.2021 Bulletin 2021/35**

(51) Int Cl.:
**H03K 5/133** (2014.01)  **H03K 7/08** (2006.01)

(21) Application number: **21154761.7**

(22) Date of filing: **02.02.2021**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **26.02.2020 TR 202002921**

(71) Applicant: **Aselsan Elektronik Sanayi Ve Tic. A.S.
Yenimahalle, Ankara (TR)**

(72) Inventors:
• **FİLC , FİLİZ ECE
Ankara (TR)**

• **AÇIKEL, VOLKAN
Ankara (TR)**
• **DOGAN, AYLKİN
Ankara (TR)**
• **CANSIZ, GÖKHAN
Ankara (TR)**

(74) Representative: **Yamankaradeniz, Kemal
Destek Patent, Inc.
Maslak Mah.,
Büyükdere Cad., No: 243,
Kat: 13, Spine Tower, Sariyer,
34485 Istanbul (TR)**

(54) **A METHOD FOR GENERATING FULLY DIGITAL HIGH-RESOLUTION FEEDBACK PWM SIGNAL**

(57)    The invention relates to a method for generating digital, high resolution pulse width modulation (PWM) signals and a digital feedback correction method suited to the method of generation intended for use in feed forward systems, feedback systems and combined feed forward and feedback systems.

Figure 1

EP 3 872 989 A1

## Description

### Technical Field

The present invention relates to a method for generating fully digital, high resolution feedback Pulse Width Modulation (PWM) signal.

The invention particularly relates to a method for generating fully digital, high resolution and high frequency feedback PWM (pulse width modulation) signal by means of FPGAs (Field Programmable Gate Arrays) in DC - DC, AC - DC conversion and switching power amplifier systems.

### Prior Art

PWM is a method of generating the desired analog electrical value or signal at the output by the way of controlling the width of generated pulses. While generating PWM signals, the desired signal is compared to a given triangular wave to calculate the necessary pulse width within the triangle wave period. The PWM technique is based on generating a square wave composed of pulse widths generated by comparison and varying with the triangle wave period used for the said comparison. The said square wave typically takes average size of the reference wave. PWM ensures power control in communication systems, power supplies, power transfer circuits and signal amplifiers.

Power amplifiers are electronic circuits transferring a part of the power drawn from power supplies as input signal or a part of the input signal to load. Power amplifiers essentially draw power from a DC power supply and convert this power to a ready - to - use AC signal by taking input signal as reference. The type of AC power signal at the output terminal of the power amplifier is controlled by the input signal.

Switching power supplies can provide PWM - controlled, quick transfer response with high power density and high efficiency. PWM - controlled current - mode power amplifiers are used in magnetic resonance imaging devices to drive gradient coil elements.

FPGAs (Field Programmable Gate Arrays) are digital integrated circuits consisting of programmable logic blocks and interconnections between these blocks. The function of each logic block can be adjusted by the user. Programmable logic blocks are embedded in the interconnections. Their configuration and communication between them is achieved through interconnections. The input - output blocks establish the connection between the intermedia connections and the package legs of the integrated circuit.

In the prior art, during digital PWM generation resolution is limited to clock frequency of the digital board, which reduces PWM resolution in high frequencies and leads to disturbances in the signal.

Patent application numbered CN10507414 is encountered in the literature as an example of the prior art. The application relates to a design method for a wide - area time - delay PID damping controller of an electrical system. However, the said invention makes no mention of increasing the resolution of PWM signal by using the IODELAY function on FPGA and the feedback system developed for the purpose.

Literature review of the prior art also revealed another publication, namely "An Efficient Strategy to Generate High Resolution Three - Phase Pulse Width Modulation Signal Based on Field Programmable Gate Array". The article describes the method for generating sinusoidal PWM signals. However, the said article also makes no mention of generating PWM signals by making corrections using feedback.

In conclusion, the drawbacks explained above and the shortcomings in existing solutions to the problems have necessitated improvement in the related technical field.

### Summary of the Invention

The present invention is developed by taking inspiration from the existing conditions and aims to eliminate the drawbacks explained above.

The primary object of the invention is to provide a system for generating fully digital high resolution PWM (Pulse Width Modulation) signal with feedback.

Another object of the invention is to control switching full bridge power amplifiers by way of the generated fully digital high resolution PWM.

One other object of the invention is to generate high - frequency PWM without reducing resolution and causing disturbances in signals.

In order to achieve the objectives specified above, the invention relates to a method for generating digital, high resolution pulse width modulation signals and a digital feedback correction method suited to the method of generation intended for use in feed forward systems, feedback systems and combined feed forward and feedback systems, comprising the following process steps :

a. Reading the current signal values to be fed into the system by the user;

b. Calculating the voltage value of the read current value at feed forward block;

c. Calculating pulse widths at pulse width calculation block by comparing the calculated voltage values with a high - frequency triangular wave;

d. Calculating the counter and tap values of the digital integrated circuit corresponding to the calculated pulse widths by using sample numbers and values;

e. Sampling the disturbed output signal by an analog digital converter;

f. Transmitting the disturbed output signal to the proportional - integral - derivative controller to calculate the correction value at the controller;

g. Correcting the counter and tap values calculated in step d by using the calculated correction values;

h. Transmitting the corrected counter and tap values to output to generate PWM signal;

i. Applying delay to increasing and decreasing edges of the PWM signal at the output by way of IO delay elements in order to increase signal resolution with centre - aligned or edge - aligned signals.

The below drawings and the detailed description referring to these drawings provide for a clearer understanding of the structural and characteristic properties and all benefits of the present invention; therefore, the evaluation needs to take these drawings and the detailed description into account.

**Brief Description of the Drawings**

Figure 1        shows a block diagram view of the combined feed forward and feedback system used in the PWM modulation according to the invention.

Figure 2        shows a block diagram view of the feedback system used in the PWM modulation.

Figure 3        shows a block diagram view of the feed forward system used in the PWM modulation.

Figure 4a       shows a view of the PWM signal generated by centre - aligned counter and tap values.

Figure 4b       shows a view of the PWM signal generated by edge - aligned counter and tap values.

Figure 5        shows a view of the feed forward and feedback system in centre - aligned PWM signal generation.

Figure 6        shows a view of the feed forward and feedback system in edge - aligned PWM signal generation.

Figure 7        shows a view of the feed forward and feedback system for full bridge in centre - aligned PWM signal generation.

**List of Reference Symbols**

| | |
|---|---|
| u(t) : | Desired Signal |
| y(t) : | Disturbed Output Signal |
| FFB : | Feed Forward Block |
| FB : | Feedback Block |
| PWCB : | Pulse Width Calculation Block |
| M : | Pulse Width Modulator |

STCB :          Signal and Tap Calculation Block
FBS :           Full Bridge Switching
ADC :          Analog Digital Converter
PID :           Proportional - Integral - Derivative Controller
S :             Current / Voltage Sensor
$F_{counter}$ :    FPGA Counter Clock Frequency
$F_{PWM}$ :     PWM Frequency
IO :           IO Delay Element

## Detailed Description of the Invention

This detailed description discloses a method for generating fully digital, high resolution feedback pulse width modulation (PWM) signal by the way of the IO Delay element (10) presented according to the invention and preferred embodiments of the invention in order to facilitate a better understanding of the present invention.

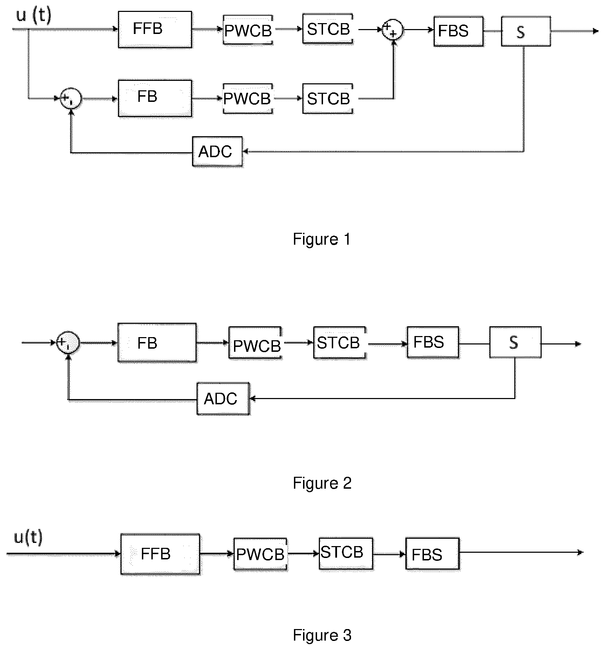

The invention typically relates to a method for generating digital, high resolution pulse width modulation (PWM) signals and a digital feedback correction method suited to the method of generation intended for use in feed forward systems, feedback systems and combined feed forward and feedback systems, respectively shown in Figure 1, Figure 2 and Figure 3. The said method can be used in full bridge D class power amplifiers, AC - DC, DC - DC, DC - AC convertors and all systems driven by PWM signals.

In standard PWM, PWM pulses are generated by use of analog mixers, while in digital generation output widths are created by comparing FPGAs (Field Programmable Gate Arrays) with a variable calculated according to the clock used on digital integrated circuits. Therefore, if the resolution of pulse widths provided in the standard method are calculated at the single edge of the clock signal, it can have a single period or two half - periods as increase and decrease at both edges.

In the method according to the invention, the lowest resolution is increased depending on the control bit number of input - output delay (IOD) elements by means of IOD elements. $F_{tap}$ value is calculated at the signal and tap calculation block (STCB) as IOD tap frequency by using the below formula :

$$F_{tap} = F_{IOdelayclock} \times (2^{nbit} + 2) \quad (1)$$

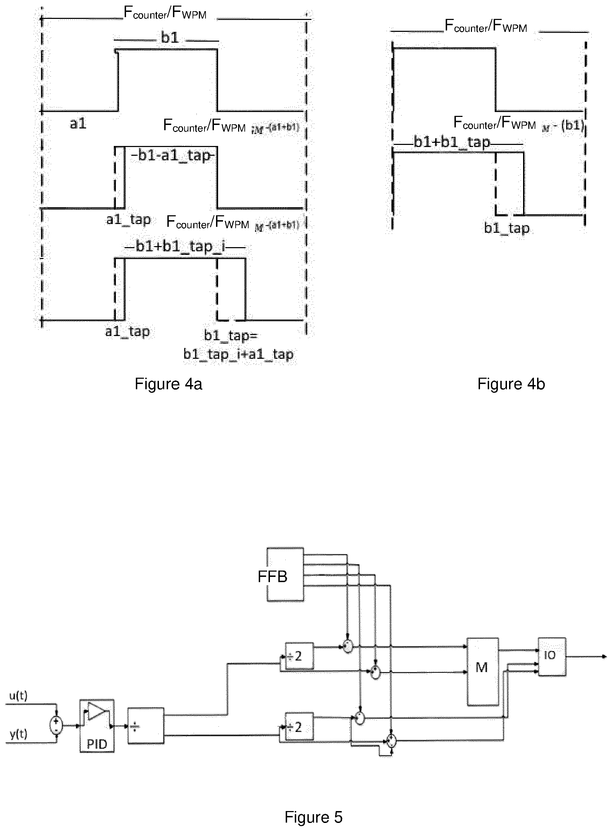

Delays in the method according to the invention can be center - aligned as shown in Figure 4a or edge - aligned as shown in Figure 4b. Figure 4a shows a1 logic at 0 as the total of a1_counter and a1_tap values with a1_counter as the counter value used by FPGA and a1_tap as the last bit value counted at the counter. a1_counter is counted with the counter used by the digital integrated circuit - FPGA - and the last counted bit is delayed by tap counter at the rate of a1_tap. Figure 4a shows b1 logic at 1 as the total of b1_counter and b1_tap values. b1_counter is counted with the counter used by FPGA and the last counted bit is delayed by tap counter at the rate of b1_tap.

Current / voltage output values are read by way of the current / voltage sensor (S). Then, voltage value of the current value read at the forward feed block (FFB) is calculated.

The voltage value required to generate the current value desired by the user at forward feed block (FFB) is calculated by using the driven load values. After comparing the calculated voltage value with triangular wave, pulse widths are calculated at the pulse width calculation block (PWCB). Counter and tap values that correspond to the calculated pulse widths are determined based on the edge - aligned or centre - aligned PWM signal. The current value applied to the load is read by the current / voltage sensor (S). The read current value is sampled by Analog Digital Converter (ADC), converted to digital, and the error value between the digital value and the current value desired to be fed by the user (disturbed output signal y(t)) is calculated. The disturbed output signal y(t) is transmitted to proportional - integral - derivative (PID) controller and the correction value is calculated at the proportional - integral - derivative (PID) controller. The pulse amplitude corresponding to the correction value and the counter and tap values corresponding to the pulse amplitude are calculated and used to correct the values calculated at the feed forward line.

To generate the centre - aligned signal shown in Figure 4a, duty cycle ($duty_n$) value is subtracted from $F_{tap}$ / $F_{WPM}$ value and divided by two to calculate the sample number ($O_n$) of the initial 0 section. Duty cycle value is calculated by comparing the desired signal with triangular wave used to generate PWM signal. Duty cycle value is the rate of the period where the desired signal (u(t)) value is higher than triangular wave to pulse period. This rate is calculated for each period of the triangular wave. a1, a1_tap, b1, b1_tap values are calculated using the $duty_n$ and $O_n$ values and below formulas for centre - aligned PWM generation :

$$a1 = fixed(O_n / F_{tap} / F_{counter}) \quad (2)$$

$$a1_{tap} = O_n - (fixed(O_n \,/\, (F_{tap} \,/\, F_{counter}))) X (F_{tap} \,/\, F_{counter}) \qquad (3)$$

$$b1 = fixed(duty_n \,/\, (F_{tap} \,/\, F_{counter}) \qquad (4)$$

$$b1_{tap_i} = duty_n - (fixed(duty_n \,/\, (F_{tap} \,/\, F_{counter}) X (F_{tap} \,/\, F_{counter}) \qquad (5)$$

Following the calculations, the disturbed output signal y(t) is sampled by means of analog digital converter (ADC). Disturbed output signal y(t) is transmitted from the desired signal u(t) to proportional - integral - derivative (PID) controller and the correction value is calculated at the proportional - integral - derivative (PID) unit.

PWM signal is generated at FPGA by counting a1 and b1 counter values at $F_{counter}$ frequency. After counting 0 at the rate of a1 and 1 at the rate of b1, the sample number of total period is counted as 0 to obtain $F_{counter}/F_{WPM}$ and to pass on to the next period of signal. Delays are applied to increasing and decreasing edges at the output by means of IO delay elements.

Delay at the rate of a1_tap value is applied to the increasing edge of the signal shown in Figure 4a. Since the delay is only applied to the edge, the pulse's section 1 is shortened at the rate of a1_tap. In order correct the shortening, tap value to be applied to the decreasing edge is calculated using the below formula :

$$b1\_tap = b1\_tap\_i + a1\_tap \qquad (6)$$

When input - out delay (IOD) elements are controlled by n bit, tap values need to be within the range of 0 - ($2^n$ - 1). This is why $F_{tap} \,/\, F_{sayaç}$ ratio is adjusted to be maximum $2^n$. If b1_tap value calculated using formula (6) is bigger than $F_{tap} \,/\, F_{sayaç}$ b1 counter value is added 1, then ($F_{tap}/ F_{sayaç}$) - 1 is subtracted from b1_tap value $F_{tap} \,/\, F_{sayaç}$ to update b1 and b1_tap values.

b1, b1_tap values calculated using the $duty_n$ value are sufficient to generate the edge - aligned PWM signal shown in Figure 4b.

$$b1 = fixed(duty_n \,/\, (F_{tap} \,/\, F_{counter}) \qquad (7)$$

$$b1_{tap} = duty_n - (fixed(duty_n \,/\, (F_{tap} \,/\, F_{sayaç}))) X (F_{tap} \,/\, F_{counter}) \qquad (8)$$

PWM signal is generated at FPGA by counting b1 counter values at $F_{counter}$ frequency. After counting 1 at the rate of b1 at the beginning of period, the sample number of total period is counted as 0 to obtain $F_{counter}/F_{WPM}$ and to pass on to the next period of signal. Delays are applied to decreasing edges at the output by means of IO delay elements. As shown in Figure 4b, the calculated b1_tap value is applied to the decreasing edge to generate the desired WPM signal.

When full - bridge switching (FBS) is used as switching mode power amplifier, the following formulas are used to calculate the duty sample numbers for left and right bridge (direction of current configured from left to right) by using the $duty_n$ value for centre - aligned WPM signal.

$$left\_duty_n = \left( \frac{\frac{F_{tap}}{F_{DGM}}}{2} \right) + duty_n \,/\, 2 \qquad (9)$$

$$righ\_duty_n = \left( \frac{\frac{F_{tap}}{F_{DGM}}}{2} \right) - duty_n \,/\, 2 \qquad (10)$$

After calculating the duty sample numbers for left and right bridges, counter and tap values for left and right bridges are calculated using the centre - aligned method shown in Figure 4a to generate two separate PWM signals.

Counter and tap values obtained at the feed forward block (FFB) output shown in Figure 1, Figure 2 and Figure 3 are updated using the data coming from feedback block (FB) and transmitted to pulse width modulator (M).

Figure 5 shows the system to update feed forward system parameters for feed forward system of centre - aligned and half - bridge switching power amplifier. As shown in Figure 3, disturbed output signal y(t) is sampled by analog digital converter (ADC) and transmitted to FPGA. In Figure 5, disturbed output signal y(t) is removed from the desired signal u(t) to enter the proportional - integral - derivative (PID) controller. Proportional - integral - derivative (PID) controller parameters need to be calculated according to the system in use. Correction value ($duty_{n\_PID}$) corresponding to the value of how much the duty value will be increased or decreased is calculated based on $F_{tap}$ frequency at the output of proportional - integral - derivative (PID) controller block. This value is divided by $F_{tap}$ /$F_{counter}$ to calculate counter_PID and tap_PID values corresponding to b1_PID and b1_tap_PID. These values are divided by 2 to calculate the a1_PID, a1_tap_PID values shown in Figure 5.

Updated counter and tap values to generate PWM signal are calculated using the formulas below :

$$a1\_updated = a1 - a1\_PID \quad (11)$$

$$b1\_updated = b1 + b1\_PID \quad (12)$$

$$a1\_tap\_updated = a1\_tap - a1\_tap\_PID \quad (13)$$

$$b1\_tap\_updated = b1\_tap + b1\_tap\_PID - a1\_tap\_PID \quad (14)$$

a1_tap_PID value needs to be taken into account while calculating b1_tap_updated in order not to shorten the 1 period. If tap value is smaller than 0 as a result of the addition and subtraction operations made while calculating the updated counter tap values, 1 is subtracted from the relevant counter is $F_{tap}$ / $F_{counter}$ added to update the tap value.

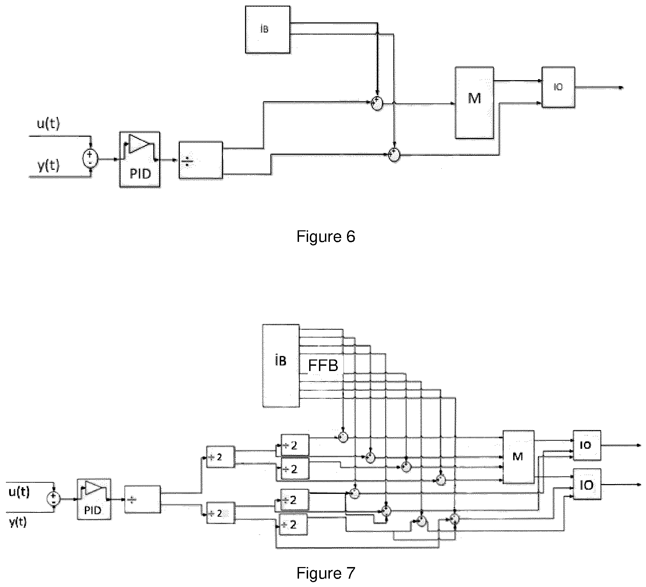

Figure 6 shows the system to update feed forward system parameters for feed forward system of edge - aligned and half - bridge switching power amplifier by means of the feed forward block (FFB). b1_PID, b1_tap_PID values are calculated in Figure 6 are calculated after calculating the counter_PID and tap_PID values shown in Figure 5. The below formulas are used to calculate the updated counter and tap values to be used to generate PWM signal:

$$b1\_updated = b1 + b1\_PID \quad (15)$$

$$b1\_tap\_updated = b1\_tap + b1\_tap\_PID \quad (16)$$

Figure 7 shows the feedback and feed forward system for full - bridge centre - aligned PWM signal generation. Since the direction of current on load is from left to right and the voltage is calculated as the difference between left and right, the difference between both sides in full bridge gives the desired duty value. Therefore, correction amount obtained at the proportional - integral - derivative (PID) controller output needs to be applied to the difference. counter - PID is divided by 2, where left_b1_PID is the division and right_a1_PID is the remainder. The same operations are performed for pat_PID to calculate left_b1_tap_PID, right_b1_tap_PID, left_a1_tap_PID and right_a1_tap_PID values. Formulas (11), (12), (13), and (14) are applied to calculated values to obtained updated counter and tap values and updated PWM signals are generated.

After generating the PWM signal, control signals of sub and top switches in each bridge is configured in reverse. Configuring control signals in reverse is known as the bridge drive method. According to this method, one of the switches is coupled to voltage source, while the other is coupled to earth. Voltage is fed to the load as long as desired while one of the switches is on and the other off.

According to another preferred embodiment of the invention, idle time adjustment circuits can be used between the circuits. While using the idle time adjustment circuit, voltage supply is protected by preventing both switches (used to couple load to voltage supply or earth) from being on at the same time. Control signal of each switch can be applied as digital WPM signal and the reverse signal. Moreover, idle time period between switches can be added to counter, tap or counter + tap periods of reverse signals. Calculations made in systems where each switch is separately controlled can be repeated based on the scenario of use.

**Claims**

1.  A method for generating digital, high resolution pulse width modulation signals, used in feed forward systems, feedback systems and combined feed forward and feedback systems, and a digital feedback correction method suited to the said generation method, and **characterized by** comprising the process steps of

    a. reading current signal values to be fed into the system by the user;
    b. calculating the voltage value of the read current value at feed forward block (FFB);
    c. calculating pulse widths at pulse width calculation block (PWCB) by comparing the calculated voltage values with a high frequency triangular wave;
    d. calculating the counter and tap values of the digital integrated circuit corresponding to the calculated pulse widths by using sample numbers and values;
    e. sampling the disturbed output signal y(t) by an analog digital converter (ADC);
    f. transmitting the disturbed output signal y(t) to the proportional - integral - derivative (PID) controller to calculate the correction value at the proportional - integral - derivative (PID) controller;
    g. correcting the counter and tap values calculated in step d by using the calculated correction values;
    h. transmitting the corrected counter and tap values to output to generate PWM signal;
    i. applying delay to increasing and decreasing edges of the PWM signal at the output by way of IO delay elements in order to increase signal resolution with centre - aligned or edge - aligned signals.

Figure 1

Figure 2

Figure 3

$F_{counter}/F_{WPM}$

b1

a1      $F_{counter}/F_{WPM}$ $_{M-(a1+b1)}$

−b1−a1_tap−

a1_tap      $F_{counter}/F_{WPM}$ $_{M-(a1+b1)}$

−b1+b1_tap_i—

a1_tap         b1_tap=
b1_tap_i+a1_tap

Figure 4a

$F_{counter}/F_{WPM}$

$F_{counter}/F_{WPM}$ $_{M-(b1)}$
—b1+b1_tap—

b1_tap

Figure 4b

Figure 5

Figure 6

Figure 7

Europäisches
Patentamt

European
Patent Office

Office européen
des brevets

# EUROPEAN SEARCH REPORT

Application Number

EP 21 15 4761

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X | JP H10 42569 A (HITACHI LTD) 13 February 1998 (1998-02-13) * the whole document * | 1 | INV. H03K5/133 H03K7/08 |
| A | US 2006/227861 A1 (MAKSIMOVIC DRAGAN [US] ET AL) 12 October 2006 (2006-10-12) * paragraph [0028] - paragraph [0033]; figures 1-4,9-10 * * paragraph [0042] - paragraph [0056] * | 1 | |
| A | US 2017/126119 A1 (BERNARDON DEREK [AT]) 4 May 2017 (2017-05-04) * figures 2-8 * | 1 | |

TECHNICAL FIELDS
SEARCHED    (IPC)

G01R
H02M
H03K

The present search report has been drawn up for all claims

| Place of search | Date of completion of the search | Examiner |
|---|---|---|
| Munich | 16 July 2021 | Mesplede, Delphine |

CATEGORY OF CITED DOCUMENTS

X : particularly relevant if taken alone
Y : particularly relevant if combined with another
    document of the same category
A : technological background
O : non-written disclosure
P : intermediate document

T : theory or principle underlying the invention
E : earlier patent document, but published on, or
    after the filing date
D : document cited in the application
L : document cited for other reasons

& : member of the same patent family, corresponding
    document

EPO FORM 1503 03.82 (P04C01)

## ANNEX TO THE EUROPEAN SEARCH REPORT
## ON EUROPEAN PATENT APPLICATION NO.

EP 21 15 4761

This annex lists the patent family members relating to the patent documents cited in the above-mentioned European search report.
The members are as contained in the European Patent Office EDP file on
The European Patent Office is in no way liable for these particulars which are merely given for the purpose of information.

16-07-2021

| Patent document cited in search report | | Publication date | Patent family member(s) | | Publication date |
|---|---|---|---|---|---|
| JP H1042569 | A | 13-02-1998 | NONE | | |
| US 2006227861 | A1 | 12-10-2006 | NONE | | |
| US 2017126119 | A1 | 04-05-2017 | CN 106849655 | A | 13-06-2017 |
| | | | DE 102016120388 | A1 | 04-05-2017 |
| | | | US 2017126119 | A1 | 04-05-2017 |

EPO FORM P0459

For more details about this annex : see Official Journal of the European Patent Office, No. 12/82

**REFERENCES CITED IN THE DESCRIPTION**

**Patent documents cited in the description**

*   CN 10507414